# EUROPEAN PATENT APPLICATION

(11) **EP 4 542 243 A1**
(43) Date of publication of application: **23.04.2025**
(21) Application number: 22961247.8
(22) Date of filing: 08.10.2022
(51) Int. Cl.: G01R 31/367

(54) **BATTERY LITHIUM PLATING MAPPING ACQUISITION METHOD, APPARATUS, DEVICE, MEDIUM, AND PROGRAM PRODUCT**

(71) Applicant: Contemporary Amperex Technology (Hong Kong) Limited, Central, Central And Western District (HK)
(72) Inventor: LI, Xiaotong, Ningde, Fujian 352100 (CN); WU, Xingyuan, Ningde, Fujian 352100 (CN)
(74) Representative: Gong, Jinping
(86) International application number: PCT/CN2022/123839
(87) International publication number: WO 2024/073890

(57) **Abstract**

The present application relates to a method and apparatus for obtaining a battery lithium precipitation window, a device, a medium, and a program product. The method includes: obtaining battery working condition information and an electrochemical model of a target battery; and then performing, by using the electrochemical model of the target battery, simulation processing on a battery charging process corresponding to the obtained battery working condition information, so as to obtain a lithium precipitation window corresponding to the battery working condition information. It can be learned that in the embodiments of the present application, battery lithium precipitation windows corresponding to different battery working conditions and/or different battery parameters can be calculated without a need to make test batteries, which can not only reduce a test period, but also save a large amount of test resources, thereby helping increase a research and development speed and save research and development costs.

## Description

### Technical Field

The present application relates to the field of batteries, and in particular, to a method and apparatus for obtaining a battery lithium precipitation window, a device, a medium, and a program product.

### Background Art

When lithium-ion batteries are charged under different temperatures, a charging strategy needs to be considered. If the charging strategy is unreasonable (for example, a rate is too large), lithium metal may be precipitated on an anode surface of the lithium-ion battery (also known as lithium precipitation). Lithium precipitation greatly affects the lifespan and safety of lithium-ion batteries. Therefore, in a design process of lithium-ion batteries, there is a need to fully consider a lithium precipitation window, under an actual charging working condition, of a lithium-ion battery to be designed.

The so-called continuous lithium precipitation window (Anode Lithium Plating Mapping, ALP Mapping) refers to a maximum charging current for continuous charging under different temperatures from different states of charge (SOC) to a specified SOC without causing lithium precipitation. In the conventional technology, a three-electrode stacking experimental test method is usually used. For different test temperatures and/or different test conditions in this test method, there is a need to make corresponding test batteries separately for testing.

It can be learned that the conventional technology requires a long overall test period and needs to consume a large amount of test resources.

### Summary

In view of the above problems, the present application provides a method and apparatus for obtaining a battery lithium precipitation window, a device, a medium, and a program product, which can solve problems of a long test period and a need for consumption of a large amount of test resources in the conventional technology.

In a first aspect, the present application provides a method for obtaining a battery lithium precipitation window, including:
obtaining battery working condition information and an electrochemical model of a target battery; and
performing, by using the electrochemical model of the target battery, simulation processing on a battery charging process corresponding to the battery working condition information, so as to obtain a lithium precipitation window corresponding to the battery working condition information.

In the technical solutions of the embodiments of the present application, through the method of performing, by using the obtained electrochemical model of the target battery, simulation processing on the battery charging process corresponding to the battery working condition information, battery lithium precipitation windows corresponding to different battery working conditions and/or different battery parameters can be calculated without a need to make test batteries, which can not only reduce a test period, but also save a large amount of test resources, thereby helping increase a research and development speed and save research and development costs.

In some embodiments, obtaining an electrochemical model of a target battery includes:
obtaining target battery model information corresponding to the target battery; and
establishing the electrochemical model of the target battery based on the target battery model information.

In some embodiments, obtaining target battery model information corresponding to the target battery includes:
obtaining battery parameter information of the target battery; and
determining, from a battery model library based on the battery parameter information, the target battery model information matching the battery parameter information.

In the technical solutions of the embodiments of the present application, through the method of performing, by using the electrochemical model of the target battery established based on the target battery model information that is automatically matched based on the battery parameter information, simulation processing on the battery charging process corresponding to the battery working condition information, battery lithium precipitation windows corresponding to different battery working conditions and/or different battery parameters can be calculated without a need to make test batteries, which can not only reduce a test period, but also save a large amount of test resources, thereby helping increase a research and development speed and save research and development costs. In addition, in the embodiments of the present application, a test result with higher accuracy can be obtained quickly by automatic matching without a need for a user to have professional simulation knowledge, implementing a wider application range.

In some embodiments, the battery parameter information includes battery material information, and the determining, from a battery model library based on the battery parameter information, the target battery model information matching the battery parameter information includes:
determining, from the battery model library based on the battery material information, the target battery model information matching the battery material information.

In some embodiments, the battery parameter information includes battery design information, and the determining, from a battery model library based on the battery parameter information, the target battery model information matching the battery parameter information includes:
determining, from the battery model library based on the battery design information, the target battery model information matching the battery design information.

In some embodiments, the battery parameter information includes battery material information and battery design information, and the determining, from a battery model library based on the battery parameter information, the target battery model information matching the battery parameter information includes:
determining, from the battery model library based on the battery material information, candidate battery model information matching the battery material information; and
determining, from the candidate battery model information based on the battery design information, the target battery model information matching the battery design information.

In some embodiments, the battery material information includes at least one of positive and negative electrode material information, separator material information, electrolyte material information, and current collector material information.

In some embodiments, the battery design information includes at least one of a battery capacity, a compacted density, a capacity per gram, and an electrode plate size.

In some embodiments, the battery working condition information includes a target temperature and a target state of charge (SOC), and the performing, by using the electrochemical model of the target battery, simulation processing on a battery charging process corresponding to the battery working condition information, so as to obtain a lithium precipitation window corresponding to the battery working condition information includes:
performing simulation processing on the battery charging process under the target temperature by using the electrochemical model of the target battery, so as to obtain a mapping relationship between a maximum charge rate and a SOC corresponding to the target temperature; and
determining, based on the target SOC and the mapping relationship, a lithium precipitation window corresponding to the target SOC.

In the technical solutions of the embodiments of the present application, simulation processing is performed on the battery charging process under the target temperature by using the electrochemical model of the target battery, so as to obtain the mapping relationship between the maximum charge rate and the SOC corresponding to the target temperature; and the lithium precipitation window corresponding to the target SOC is determined based on the target SOC and the mapping relationship. It can be learned that, in the embodiments of the present application, through the method of performing, by using the electrochemical model of the target battery, simulation processing on the battery charging process under the target temperature, battery lithium precipitation windows corresponding to different battery working conditions and/or different battery parameters can be calculated without a need to make test batteries, which can not only reduce a test period, but also save a large amount of test resources, thereby helping increase a research and development speed and save research and development costs.

In some embodiments, the battery charging process includes a process of charging a battery at different maximum charge rates from when a remaining electricity amount of the battery is an initial SOC, and the performing simulation processing on the battery charging process under the target temperature by using the electrochemical model of the target battery, so as to obtain a mapping relationship between a maximum charge rate and a SOC corresponding to the target temperature includes:
performing simulation processing on the battery charging process under the target temperature by using the electrochemical model of the target battery, so as to obtain a plurality of groups of simulation results, where each group of simulation results includes a maximum charge rate and a corresponding SOC; and
obtaining the mapping relationship based on the plurality of groups of simulation results.

In some embodiments, determining, based on the target SOC and the mapping relationship, a lithium precipitation window corresponding to the target SOC includes:
obtaining, based on the target SOC and the mapping relationship, a target maximum charge rate corresponding to the target SOC; and
determining the lithium precipitation window based on the target maximum charge rate and a battery capacity of the target battery.

In a second aspect, the present application provides an apparatus for obtaining a battery lithium precipitation window, including:
an obtaining module configured to obtain battery working condition information and an electrochemical model of a target battery; and
a simulation module configured to perform, by using the electrochemical model of the target battery, simulation processing on a battery charging process corresponding to the battery working condition information, so as to obtain a lithium precipitation window corresponding to the battery working condition information.

According to a third aspect, the present application provides an electronic device, including a memory and a processor, where the memory stores a computer program, and when the processor executes the computer program, the steps of the method for obtaining a battery lithium precipitation window according to any one of the embodiments of the first aspect are implemented.

According to a fourth aspect, the present application provides a computer-readable storage medium, where the computer-readable storage medium stores a computer program, and when the computer program is executed by a processor, the steps of the method for obtaining a battery lithium precipitation window according to any one of the embodiments of the first aspect are implemented.

According to a fifth aspect, the present application provides a computer program product, where the computer program product includes a computer program, and when the computer program is executed by a processor, the steps of the method for obtaining a battery lithium precipitation window according to any one of the embodiments of the first aspect are implemented.

The above description is only an overview of the technical solutions of the present application. In order to more clearly understand the technical means of the present application to implement same according to the contents of the description, and in order to make the above and other objectives, features and advantages of the present application more obvious and understandable, specific implementations of the present application are exemplarily described below.

### Brief Description of the Drawings

Various other advantages and benefits will become apparent to those of ordinary skill in the art upon reading the following detailed description of preferred implementations. Accompanying drawings are merely for the purpose of illustrating the preferred implementations and are not to be construed as limiting the present application. Moreover, the same reference numerals represent the same components throughout the accompanying drawings. In the drawings:
FIG. 1 is a schematic diagram of an application environment according to an embodiment of the present application;
FIG. 2 is a schematic flowchart of a method for obtaining a battery lithium precipitation window according to some embodiments of the present application;
FIG. 3 is a schematic flowchart of a method for obtaining a battery lithium precipitation window according to some other embodiments of the present application;
FIG. 4 is a schematic flowchart of a method for obtaining a battery lithium precipitation window according to some other embodiments of the present application;
FIG. 5 is a schematic flowchart of a method for obtaining a battery lithium precipitation window according to some other embodiments of the present application;
FIG. 6 is a schematic flowchart of a method for obtaining a battery lithium precipitation window according to some other embodiments of the present application;
FIG. 7 is a schematic flowchart of a method for obtaining a battery lithium precipitation window according to some other embodiments of the present application;
FIG. 8 is a schematic diagram of a structure of an apparatus for obtaining a battery lithium precipitation window according to some embodiments of the present application; and
FIG. 9 is a schematic diagram of a structure of an electronic device according to an embodiment of the present application.

### Detailed Description of Embodiments

Embodiments of the technical solutions of the present application will be described in detail below with reference to the accompanying drawings. The following embodiments are merely intended to more clearly illustrate the technical solutions of the present application, so they merely serve as examples, but are not intended to limit the scope of protection of the present application.

Unless otherwise defined, all technical and scientific terms used herein have the same meanings as those commonly understood by those skilled in the art to which the present application belongs. The terms used herein are merely for the purpose of describing specific embodiments, but are not intended to limit the present application. The terms "including" and any variations thereof in the specification and the claims of the present application and in the foregoing brief description of the drawings are intended to cover non-exclusive inclusions.

In the description of the embodiments of the present application, the technical terms "first", "second", etc. are merely used for distinguishing different objects, and are not to be construed as indicating or implying relative importance or implicitly indicating the number, particular order or primary-secondary relationship of the indicated technical features. In the description of the embodiments of the present application, the phrase "a plurality of" means two or more (including two), unless otherwise explicitly and specifically defined.

When lithium-ion batteries are charged under different temperatures, a charging strategy needs to be considered. If the charging strategy is unreasonable (for example, a rate is too large), lithium metal is precipitated on an anode surface of the lithium-ion battery (also known as lithium precipitation). Lithium precipitation greatly affects the lifespan and safety of lithium-ion batteries. Therefore, in a design process of lithium-ion batteries, there is a need to fully consider a lithium precipitation window, under an actual charging working condition, of a lithium-ion battery to be designed.

The so-called continuous lithium precipitation window (ALP Mapping) refers to a maximum charging current for continuous charging under different temperatures from different SOCs to a specified SOC without causing lithium precipitation. In the conventional technology, a three-electrode stacking experimental test method is usually used. For different test temperatures and/or different test conditions in this test method, there is a need to make corresponding test batteries separately for testing, where it usually requires a relatively long time to make test batteries. It can be learned that the conventional technology requires a long overall test period and needs to consume a large amount of test resources (for example, material test resources).

In order to save test resources, the applicant found through research that a battery lithium precipitation window can be obtained by performing charging simulation on a battery charging process using a battery electrochemical model without a need to make test batteries, so that a large amount of test resources can be saved.

Based on the above considerations, in order to solve problems of a long test period and a need for consumption of a large amount of test resources in the conventional technology, the applicant provides, through research, a method for obtaining a battery lithium precipitation window, in this method, battery working condition information and an electrochemical model of a target battery are obtained; and then simulation processing is performed, by using the electrochemical model of the target battery, on a battery charging process corresponding to the obtained battery working condition information, so as to obtain a lithium precipitation window corresponding to the battery working condition information. It can be learned that, compared with the conventional technology, in the embodiments of the present application, through the method of performing, by using the obtained electrochemical model of the target battery, simulation processing on the battery charging process corresponding to the battery working condition information, there is no need to make test batteries, which can not only reduce a test period, but also save a large amount of test resources.

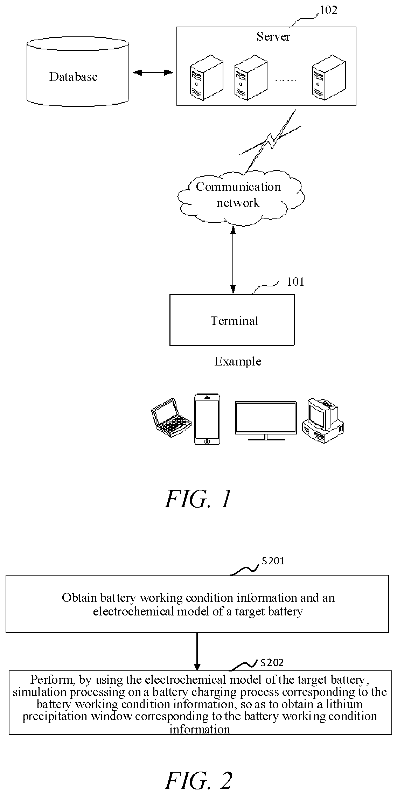

FIG. 1 is a schematic diagram of an application environment according to an embodiment of the present application. As shown in FIG. 1, in the application environment of this embodiment of the present application, a terminal 101 may communicate with a server 102 over a network. A database may store a battery model library involved in this embodiment of the present application. Certainly, the database may further store other data that needs to be processed by the server 102. This is not limited in this embodiment of the present application.

In a possible implementation, the terminal 101 may determine, by using the method for obtaining a battery lithium precipitation window provided in this embodiment of the present application, a lithium precipitation window corresponding to battery working condition information.

In another possible implementation, the terminal 101 sends the battery working condition information and the like to the server 102, such that the server 102 determines, by using the method for obtaining a battery lithium precipitation window provided in this embodiment of the present application, the lithium precipitation window corresponding to the battery working condition information. It should be understood that, in this implementation, the server 102 may also send, to the terminal 101, the determined lithium precipitation window corresponding to the battery working condition information, so as to be displayed by the terminal 101.

The database in this embodiment of the present application may be integrated on the server 102, or placed on the cloud or another network server.

The terminal 101 in this embodiment of the present application may be, but is not limited to, various personal computers, notebook computers, smart phones, and tablet computers.

The server 102 in this embodiment of the present application may be implemented by an independent server or a server cluster composed of a plurality of servers.

In some embodiments, FIG. 2 is a schematic flowchart of a method for obtaining a battery lithium precipitation window according to some embodiments of the present application. In this embodiment of the present application, that the method is applied to an electronic device is used as an example for illustration, where the electronic device may be the terminal 101 or the server 102 in FIG. 1. As shown in FIG. 2, the method in this embodiment of the present application may include the following steps.

In step S201, battery working condition information and an electrochemical model of a target battery are obtained.

The battery working condition information in this embodiment of the present application is used to indicate a battery charging working condition corresponding to a battery lithium precipitation window that needs to be obtained. Exemplarily, the battery working condition information may include: a target temperature to be detected and a target state of charge (SOC) to be detected. Certainly, the battery working condition information may further include other information (for example, a lithium precipitation condition). This is not limited in this embodiment of the present application. It should be understood that the battery working condition information in this step may be a collective name, and may include one piece of battery working condition information or a plurality of pieces of battery working condition information.

Exemplarily, the lithium precipitation condition in this embodiment of the present application may include that an anode potential of the battery is a preset voltage (for example, 0 V). Certainly, the lithium precipitation condition may further include other conditions. This is not limited in this embodiment of the present application.

In the following embodiments of the present application, an implementation of "obtaining battery working condition information" is introduced.

In a possible implementation, if the electronic device is the terminal 101 in FIG. 1, the electronic device may receive battery working condition information inputted by a user. Exemplarily, the electronic device may receive battery working condition information inputted by the user on a parameter input interface.

In another possible implementation, if the electronic device is the server 102 in FIG. 1, the electronic device may receive battery working condition information sent by the terminal 101.

Certainly, the electronic device may alternatively obtain the battery working condition information in another manner. This is not limited in this embodiment of the present application.

In the following embodiments of the present application, an implementation of "obtaining an electrochemical model of a target battery" is introduced.

In a possible implementation, the electronic device may obtain target battery model information corresponding to the target battery, and establish the electrochemical model of the target battery based on the target battery model information.

The target battery model information in this embodiment of the present application may include, but is not limited to, reference design information of the target battery and a physical property parameter of a corresponding material of the target battery.

In this implementation, the electronic device may receive target battery model information inputted by the user or target battery model information sent by other devices, or may determine the target battery model information from a battery model library. Certainly, the electronic device may alternatively obtain the target battery model information in another manner. This is not limited in this embodiment of the present application.

Further, the electronic device may establish the electrochemical model of the target battery based on the target battery model information. It should be understood that, after obtaining the target battery model information, the electronic device can establish the electrochemical model of the target battery based on the target battery model information.

In another possible implementation, the electronic device may receive an electrochemical model of the target battery that is inputted by the user, or the electronic device may receive an electrochemical model of the target battery that is sent by other devices.

Certainly, the electronic device may alternatively obtain the electrochemical model of the target battery in another manner. This is not limited in this embodiment of the present application.

In step S202, simulation processing is performed, by using the electrochemical model of the target battery, on a battery charging process corresponding to the battery working condition information, so as to obtain a lithium precipitation window corresponding to the battery working condition information.

In this step, the electronic device performs, by using the electrochemical model of the target battery that is obtained in step S201, simulation processing on the battery charging process corresponding to the battery working condition information that is obtained in step S201, so as to obtain the lithium precipitation window corresponding to the battery working condition information.

For example, the battery working condition information obtained by the electronic device includes battery working condition information 1 and battery working condition information 2, where the battery working condition information 1 includes a target temperature 1 and a target state of charge SOC1, and the battery working condition information 2 includes a target temperature 2 and a target state of charge SOC2. The electronic device may perform, by using the electrochemical model of the target battery, simulation processing on a battery charging process corresponding to the battery working condition information 1, so as to obtain a lithium precipitation window 1 corresponding to the battery working condition information 1, and perform, by using the electrochemical model of the target battery, simulation processing on a battery charging process corresponding to the battery working condition information 2, so as to obtain a lithium precipitation window 2 corresponding to the battery working condition information 2, where the lithium precipitation window 1 corresponding to the battery working condition information 1 represents a maximum charging current for charging the target battery continuously to a target SOC1 under the target temperature 1 without causing lithium precipitation, and the lithium precipitation window 2 corresponding to the battery working condition information 2 represents a maximum charging current for charging the target battery continuously to a target SOC2 under the target temperature 2 without causing lithium precipitation.

According to the above method for obtaining a battery lithium precipitation window, the battery working condition information and the electrochemical model of the target battery are obtained; and then simulation processing is performed, by using the electrochemical model of the target battery, on the battery charging process corresponding to the battery working condition information, so as to obtain the lithium precipitation window corresponding to the battery working condition information. It can be learned that, compared with the conventional technology, in this embodiment of the present application, through the method of performing, by using the obtained electrochemical model of the target battery, simulation processing on the battery charging process corresponding to the obtained battery working condition information, battery lithium precipitation windows corresponding to different battery working conditions and/or different battery parameters can be calculated without a need to make test batteries, which can not only reduce a test period, but also save a large amount of test resources, thereby helping increase a research and development speed and save research and development costs.

In order to save test resources, the applicant found through research that a battery model library that includes various types of battery model information may be established, so that corresponding battery model information can be automatically matched from the battery model library based on battery parameter information inputted by the user and a battery electrochemical model can be established, and then the battery lithium precipitation window can be obtained by performing charging simulation on the battery charging process using the battery electrochemical model without a need to make test batteries, so that not only a test period can be reduced, but also a large amount of test resources can be saved.

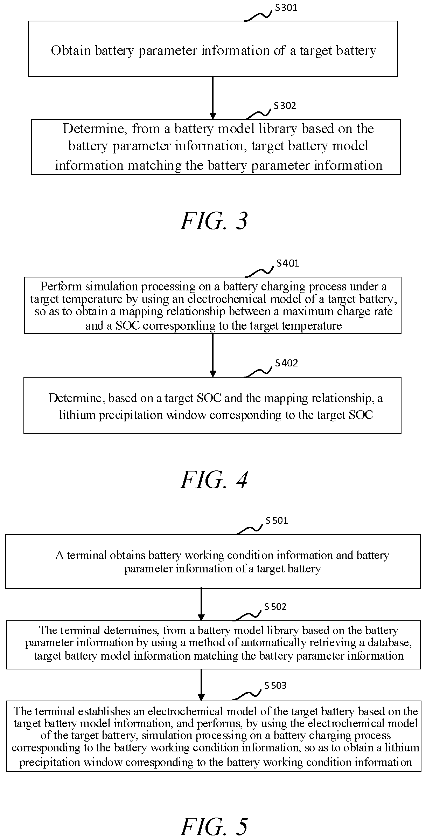

In some embodiments, FIG. 3 is a schematic flowchart of a method for obtaining a battery lithium precipitation window according to some other embodiments of the present application. On the basis of the above embodiment, related content of obtaining the target battery model information corresponding to the target battery is introduced and described in this embodiment of the present application. As shown in FIG. 3, the method in this embodiment of the present application may include the following steps.

In step S301, battery parameter information of the target battery is obtained.

The battery parameter information of the target battery in this embodiment of the present application is used to indicate key battery parameters of the target battery that needs to be designed. Exemplarily, the battery parameter information of the target battery may include, but is not limited to, battery material information and/or battery design information of the target battery, where the battery material information of the target battery is used to indicate identification information of battery materials of the target battery, and the battery design information of the target battery is used to indicate battery design parameters of the target battery.

Exemplarily, the battery material information in this embodiment of the present application may include at least one of positive and negative electrode material information, separator material information, electrolyte material information, and current collector material information. Certainly, other material information may be further included. This is not limited in this embodiment of the present application. For example, the battery material information may include names of positive and negative electrode materials, a name of a separator material, and a name of an electrolyte.

Exemplarily, the battery design information in this embodiment of the present application may include at least one of a battery capacity, a compacted density, a capacity per gram, and an electrode plate size. Certainly, other design information may be further included. This is not limited in this embodiment of the present application.

In the following embodiments of the present application, an implementation of "obtaining battery parameter information of the target battery" is introduced.

In a possible implementation, if the electronic device is the terminal 101 in FIG. 1, the electronic device may receive battery parameter information of the target battery that is inputted by the user. Exemplarily, the electronic device may receive battery parameter information of the target battery that is inputted by the user on a parameter input interface.

In another possible implementation, if the electronic device is the server 102 in FIG. 1, the electronic device may receive battery parameter information of the target battery that is sent by the terminal 101.

Certainly, the electronic device may alternatively obtain the battery parameter information of the target battery in another manner. This is not limited in this embodiment of the present application.

In step S302, target battery model information matching the battery parameter information is determined from a battery model library based on the battery parameter information.

The battery model library involved in this embodiment of the present application may be divided, according to different types of stored content, into a material library and a battery library, where the material library is used to store physical property parameters of main materials such as positive electrode materials, negative electrode materials, separator materials, electrolyte materials, and current collector materials, and each main material may include a plurality of material types. The battery library is used to store a plurality of sets of complete battery reference design information and physical property parameters of corresponding battery materials.

The battery model library involved in this embodiment of the present application may be divided, according to different models, into various types of calibrated battery model information, where any battery model information may include battery reference design information and physical property parameters of corresponding battery materials.

In this step, the electronic device determines, from the battery model library based on the battery parameter information obtained in step S301, the target battery model information matching the battery parameter information, where the target battery model information may include reference design information of the target battery and a physical property parameter of a corresponding material of the target battery.

In the following embodiments of the present application, an implementation of determining, by the electronic device from a battery model library based on the battery parameter information, target battery model information matching the battery parameter information is introduced.

In a possible implementation, if the battery parameter information of the target battery includes the battery material information of the target battery, the electronic device may determine, from the battery model library based on the battery material information, the target battery model information matching the battery material information.

In this implementation, the electronic device may perform matching between the battery material information of the target battery and a physical property parameter of a battery material in each piece of battery model information in the battery model library, and determine, as the target battery model information, battery model information to which a physical property parameter of a battery material that has the highest matching degree belongs. For example, assuming that the battery model library includes battery model information 1, battery model information 2, and battery model information 3, the electronic device performs matching between the battery material information and each of a physical property parameter 1 of a battery material in the battery model information 1, a physical property parameter 2 of a battery material in the battery model information 2, and a physical property parameter 3 of a battery material in the battery model information 3, where a matching degree 1 between the battery material information and the physical property parameter 1 of the battery material in the battery model information 1 is greater than a matching degree 2 between the battery material information and the physical property parameter 2 of the battery material in the battery model information 2, the matching degree 2 between the battery material information and the physical property parameter 2 of the battery material in the battery model information 2 is greater than a matching degree 3 between the battery material information and the physical property parameter 3 of the battery material in the battery model information 3, and therefore the electronic device may determine the battery model information 1 as the target battery model information.

Certainly, the electronic device may alternatively determine, from the battery model library based on the battery material information in another manner, the target battery model information matching the battery material information (for example, the electronic device may determine, as the target battery model information, any one piece of battery model information to which physical property parameters of battery materials whose matching degrees exceed a first matching degree belong). This is not limited in this embodiment of the present application.

In another possible implementation, if the battery parameter information of the target battery includes the battery design information of the target battery, the electronic device may determine, from the battery model library based on the battery design information, the target battery model information matching the battery design information.

In this implementation, the electronic device may perform matching between the battery design information of the target battery and battery reference design information in each piece of battery model information in the battery model library, and determine, as the target battery model information, battery model information to which battery reference design information that has the highest matching degree belongs.

Certainly, the electronic device may alternatively determine, from the battery model library based on the battery design information in another manner, the target battery model information matching the battery design information (for example, the electronic device may determine, as the target battery model information, any one piece of battery model information to which battery reference design information whose matching degrees exceed a third matching degree belong). This is not limited in this embodiment of the present application.

In another possible implementation, if the battery parameter information of the target battery includes the battery material information and the battery design information of the target battery, the electronic device may determine, from the battery model library based on the battery material information, first candidate battery model information matching the battery material information, and determine, from the first candidate battery model information based on the battery design information, the target battery model information matching the battery design information.

In this implementation, the electronic device may perform matching between the battery material information and a physical property parameter of a battery material in each piece of battery model information in the battery model library, and determine, as the first candidate battery model information, battery model information to which a physical property parameter of a battery material whose matching degree exceeds a first matching degree belongs. For example, assuming that the battery model library includes battery model information 1, battery model information 2, and battery model information 3, the electronic device performs matching between the battery material information and each of a physical property parameter 1 of a battery material in the battery model information 1, a physical property parameter 2 of a battery material in the battery model information 2, and a physical property parameter 3 of a battery material in the battery model information 3, where a matching degree 1 between the battery material information and the physical property parameter 1 of the battery material in the battery model information 1 is greater than a first matching degree, a matching degree 2 between the battery material information and the physical property parameter 2 of the battery material in the battery model information 2 is not greater than the first matching degree, a matching degree 3 between the battery material information and the physical property parameter 3 of the battery material in the battery model information 3 is greater than the first matching degree, and therefore the electronic device may determine the battery model information 1 and the battery model information 3 as the first candidate battery model information.

Further, the electronic device may perform matching between the battery design information and battery reference design information in each piece of battery model information in the first candidate battery model information, and determine, as the target battery model information, battery model information to which battery reference design information whose matching degrees exceed a second matching degree belong. For example, assuming that the first candidate battery model information includes battery model information 1 and battery model information 3, the electronic device performs matching between the battery design information and either of battery reference design information 1 in the battery model information 1 and battery reference design information 3 in the battery model information 3, where a matching degree between the battery design information and the battery reference design information 1 in the battery model information 1 is greater than a second matching degree, a matching degree between the battery design information and the battery reference design information 3 in the battery model information 3 is not greater than the second matching degree, and therefore the electronic device may determine the battery model information 1 as the target battery model information.

In another possible implementation, if the battery parameter information of the target battery includes the battery material information and the battery design information of the target battery, the electronic device may determine, from the battery model library based on the battery design information, second candidate battery model information matching the battery design information, and determine, from the second candidate battery model information based on the battery material information, the target battery model information matching the battery material information.

In this implementation, the electronic device may perform matching between the battery design information and battery reference design information in each piece of battery model information in the battery model library, and determine, as the second candidate battery model information, battery model information to which battery reference design information whose matching degrees exceed a third matching degree belong. Further, the electronic device may perform matching between the battery material information and a physical property parameter of a battery material in each piece of battery model information in the second candidate battery model information, and determine, as the target battery model information, battery model information to which physical property parameters of battery materials whose matching degrees exceed a fourth matching degree belong.

In another possible implementation, if the battery parameter information of the target battery includes the battery material information and the battery design information of the target battery, the electronic device may determine, from the battery model library based on the battery material information, first candidate battery model information matching the battery material information. Further, the electronic device may determine, from the battery model library based on the battery design information, second candidate battery model information matching the battery design information. Further, the electronic device may determine, as the target battery model information, overlapping battery model information between the first candidate battery model information and the second candidate battery model information, where the overlapping battery model information belongs to each of the first candidate battery model information and the second candidate battery model information.

It should be understood that when the target battery model information determined by the electronic device in the above manner includes a plurality of pieces of battery model information, the plurality of pieces of battery model information may be displayed through the terminal, so that the user selects the final target battery model information from the plurality of pieces of battery model information, so as to establish the electrochemical model of the target battery based on the final target battery model information.

It should be noted that if the matching degree of the target battery model information determined by the electronic device from the battery model library based on the battery parameter information is greater than a first matching degree threshold but less than a second matching threshold (that is, the matching degree is not particularly high), the electronic device may establish the electrochemical model of the target battery based on the target battery model information in conjunction with the battery parameter information obtained in step S301.

For example, the electronic device may replace, with content in the battery parameter information, content in the target battery model information that is inconsistent with the battery parameter information, and then establish the electrochemical model of the target battery based on the replaced target battery model information.

For another example, the electronic device may replace, with content in the battery material information, content in the target battery model information that is inconsistent with the battery material information in the battery parameter information, and then establish the electrochemical model of the target battery based on the replaced target battery model information.

For still another example, the electronic device may replace, with content in the battery design information, content in the target battery model information that is inconsistent with the battery design information in the battery parameter information, and then establish the electrochemical model of the target battery based on the replaced target battery model information.

In this embodiment of the present application, the battery parameter information of the target battery is obtained, and the target battery model information matching the battery parameter information is determined from the battery model library based on the battery parameter information, so that the electrochemical model of the target battery is established based on the target battery model information, and simulation processing is performed, by using the electrochemical model of the target battery, on the battery charging process corresponding to the battery working condition information, so as to obtain the lithium precipitation window corresponding to the battery working condition information. It can be learned that, in this embodiment of the present application, through the method of performing, by using the electrochemical model of the target battery that is established based on the target battery model information automatically matched, simulation processing on the battery charging process corresponding to the battery working condition information, battery lithium precipitation windows corresponding to different battery working conditions and/or different battery parameters can be calculated without a need to make test batteries, which can not only reduce a test period, but also save a large amount of test resources, thereby helping increase a research and development speed and save research and development costs. In addition, in this embodiment of the present application, a test result with higher accuracy can be obtained quickly by automatic matching without a need for a user to have professional simulation knowledge, implementing a wider application range.

In some embodiments, FIG. 4 is a schematic flowchart of a method for obtaining a battery lithium precipitation window according to some other embodiments of the present application. On the basis of the above embodiment, related content of performing simulation processing by using the electrochemical model of the target battery in step S202 is introduced and described in this embodiment of the present application. As shown in FIG. 4, the method in this embodiment of the present application may include the following steps.

In step S401, simulation processing is performed on the battery charging process under the target temperature by using the electrochemical model of the target battery, so as to obtain a mapping relationship between a maximum charge rate and a SOC corresponding to the target temperature.

In this step, the electronic device performs, according to a preset charging process by using the electrochemical model of the target battery, simulation processing on the battery charging process under the target temperature in the battery working condition information, so as to obtain the mapping relationship between the maximum charge rate and the SOC corresponding to the target temperature. Exemplarily, the mapping relationship between the maximum charge rate and the SOC corresponding to the target temperature in this embodiment of the present application is used to indicate a relationship between a different SOC under the target temperature and a corresponding maximum charge rate.

For example, the battery working condition information obtained by the electronic device includes battery working condition information 1 and battery working condition information 2, where the battery working condition information 1 includes a target temperature 1 and a target state of charge SOC1, and the battery working condition information 2 includes a target temperature 2 and a target state of charge SOC2. The electronic device performs, according to a preset charging process by using the electrochemical model of the target battery, simulation processing on a battery charging process under the target temperature 1 in the battery working condition information 1, so as to obtain a mapping relationship 1 between the maximum charge rate and a SOC corresponding to the target temperature 1, and performs, according to the preset charging process by using the electrochemical model of the target battery, simulation processing on a battery charging process under the target temperature 2 in the battery working condition information 2, so as to obtain a mapping relationship 2 between the maximum charge rate and a SOC corresponding to the target temperature 2.

For ease of understanding, in the following embodiments of the present application, related content of performing simulation processing on the battery charging process under the target temperature by using the electrochemical model of the target battery, so as to obtain a mapping relationship corresponding to the target temperature is further introduced.

Exemplarily, the electronic device may perform simulation processing on the battery charging process under the target temperature by using the electrochemical model of the target battery, so as to obtain a plurality of groups of simulation results, and obtain the mapping relationship based on the plurality of groups of simulation results, where the battery charging process may include a process of charging a battery at different maximum charge rates from when a remaining electricity amount of the battery is an initial SOC, and each group of simulation results includes a maximum charge rate and a corresponding SOC.

In this embodiment of the present application, the electronic device may simulate, by using the electrochemical model of the target battery, battery charging processes under the target temperature at different maximum charge rates from an initial SOC (for example, 0% or 2%) until a preset lithium precipitation condition is met, so as to obtain SOCs respectively corresponding to the different maximum charge rates, where each maximum charge rate and the corresponding SOC belong to one group of simulation results.

Exemplarily, the preset lithium precipitation condition in this embodiment of the present application may include that an anode potential of the battery is a preset voltage (for example, 0 V). Certainly, the preset lithium precipitation condition may further include other conditions. This is not limited in this embodiment of the present application.

It should be noted that the preset lithium precipitation condition in this embodiment of the present application may be preset in the electronic device, or may be carried in the obtained battery working condition information. Certainly, it may alternatively be obtained by the electronic device in another manner. This is not limited in this embodiment of the present application.

For example, the electronic device may simulate, by using the electrochemical model of the target battery, battery charging processes under the target temperature at maximum charge rates of Rate0, Rate1, Rate2, ..., and RateN from an initial SOC until the preset lithium precipitation condition is met, so as to obtain SOC0, SOC1, SOC2, ..., and SOCN respectively corresponding to the different maximum charge rates, where N is an integer greater than or equal to 6, Rate0 and SOC0 belong to one group of simulation results, Rate1 and SOC1 belong to one group of simulation results, Rate2 and SOC2 belong to one group of simulation results, ..., and RateN and SOCN belong to one group of simulation results.

Further, the electronic device may obtain, based on the plurality of groups of simulation results, the mapping relationship between the maximum charge rate and the SOC corresponding to the target temperature, where each group of simulation results includes a maximum charge rate and a corresponding SOC. Exemplarily, the electronic device may perform fitting processing based on a plurality of groups of simulation results, to obtain a mapping relationship between a SOC and the maximum charge rate, where an abscissa of the mapping relationship may be the SOC and an ordinate may be the maximum charge rate.

Exemplarily, the mapping relationship between the maximum charge rate and the SOC corresponding to the target temperature may be stored in the electronic device in the form of discrete data, or may be stored in the electronic device in the form of a function. Certainly, the mapping relationship may alternatively be stored in the electronic device in another form. This is not limited in this embodiment of the present application.

In step S402, a lithium precipitation window corresponding to the target SOC is determined based on the target SOC and the mapping relationship.

In this step, the electronic device may determine, based on the target SOC in the obtained battery working condition information and the mapping relationship that is obtained in step S401 and between the maximum charge rate and the SOC corresponding to the target temperature, the lithium precipitation window corresponding to the target SOC, that is, a maximum charging current for charging the target battery continuously to the target SOC under the target temperature without causing lithium precipitation.

**In** a possible implementation, the electronic device may obtain, based on the target SOC and the mapping relationship, a target maximum charge rate corresponding to the target SOC, and determine the lithium precipitation window based on the target maximum charge rate and a battery capacity of the target battery.

**In** this implementation, the electronic device may obtain, based on the target SOC and the mapping relationship between the SOC and the maximum charge rate, the target maximum charge rate corresponding to the target SOC. It should be understood that if the mapping relationship between the maximum charge rate and the SOC corresponding to the target temperature is stored in the electronic device in the form of discrete data, and a plurality of SOCs in the mapping relationship include the target SOC, the electronic device may determine, as the target maximum charge rate, a maximum charge rate corresponding to the target SOC in the mapping relationship. Alternatively, if the mapping relationship between the maximum charge rate and the SOC corresponding to the target temperature is stored in the electronic device in the form of a function, the electronic device may substitute the target SOC into the mapping relationship between the SOC and the maximum charge rate to obtain the target maximum charge rate corresponding to the target SOC.

Further, the electronic device may determine, based on a product of the target maximum charge rate and the battery capacity of the target battery, the lithium precipitation window corresponding to the target SOC, that is, a maximum charging current for charging the target battery continuously to the target SOC under the target temperature without causing lithium precipitation. It should be understood that the battery parameter information of the target battery that is obtained in step S301 includes a battery capacity of the target battery. Certainly, the battery capacity of the target battery may alternatively be obtained by the electronic device in another manner. This is not limited in this embodiment of the present application.

In another possible implementation, the electronics may obtain, based on the battery capacity of the target battery and the mapping relationship between the SOC and the maximum charge rate, the mapping relationship between the SOC and the maximum charging current, and obtain, based on the target SOC and the mapping relationship between the SOC and the maximum charging current, the lithium precipitation window corresponding to the target SOC.

In this implementation, the electronic device may convert, based on the battery capacity of the target battery, the mapping relationship between the SOC and the maximum charge rate, so as to obtain the mapping relationship between the SOC and the maximum charging current, and may therefore obtain, based on the target SOC and the mapping relationship between the SOC and the maximum charging current, the lithium precipitation window corresponding to the target SOC, that is, a maximum charging current for charging the target battery continuously to the target SOC under the target temperature without causing lithium precipitation.

In this embodiment of the present application, simulation processing is performed on the battery charging process under the target temperature by using the electrochemical model of the target battery, so as to obtain the mapping relationship between the maximum charge rate and the SOC corresponding to the target temperature, and the lithium precipitation window corresponding to the target SOC is determined based on the target SOC and the mapping relationship. It can be learned that, in this embodiment of the present application, through the method of performing, by using the electrochemical model of the target battery, simulation processing on the battery charging process under the target temperature, battery lithium precipitation windows corresponding to different battery working conditions and/or different battery parameters can be calculated without a need to make test batteries, which can not only reduce a test period, but also save a large amount of test resources, thereby helping increase a research and development speed and save research and development costs.

In some embodiments, FIG. 5 is a schematic flowchart of a method for obtaining a battery lithium precipitation window according to some other embodiments of the present application. On the basis of the above embodiment, in this embodiment of the present application, that the method for obtaining a battery lithium precipitation window is applied to a terminal is used as an example for introduction and description. As shown in FIG. 5, the method in this embodiment of the present application may include the following steps.

In step S501, the terminal obtains battery working condition information and battery parameter information of a target battery.

In step S502, the terminal determines, from a battery model library based on the battery parameter information by using a method of automatically retrieving a database, target battery model information matching the battery parameter information.

In step S503, the terminal establishes an electrochemical model of the target battery based on the target battery model information, and performs, by using the electrochemical model of the target battery, simulation processing on a battery charging process corresponding to the battery working condition information, so as to obtain a lithium precipitation window corresponding to the battery working condition information.

For an implementation of each step in this embodiment of the present application, reference may be made to related content in the above embodiment of the present application, and details are not repeated here.

In this embodiment of the present application, the terminal uses the method of performing, by using the electrochemical model of the target battery that is established based on the target battery model information automatically matched, simulation processing on the battery charging process corresponding to the battery working condition information, so that battery lithium precipitation windows corresponding to different battery working conditions and/or different battery parameters can be calculated without a need to make test batteries, which can not only reduce a test period, but also save a large amount of test resources, thereby helping increase a research and development speed and save research and development costs. In addition, in this embodiment of the present application, the terminal may independently complete the obtaining process of the battery lithium precipitation window without interacting with a server, thereby saving an interaction process and helping improve the obtaining efficiency of the battery lithium precipitation window.

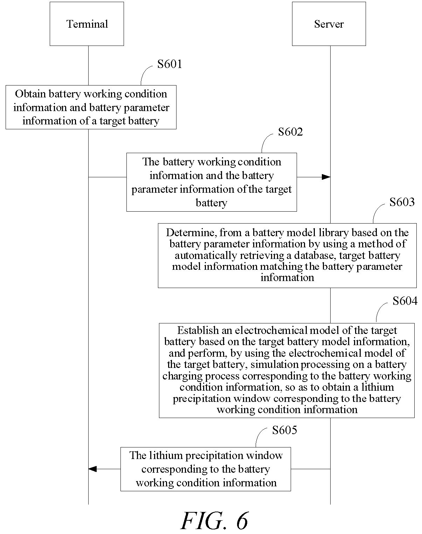

In some embodiments, FIG. 6 is a schematic flowchart of a method for obtaining a battery lithium precipitation window according to some other embodiments of the present application. On the basis of the above embodiment, in this embodiment of the present application, the method for obtaining a battery lithium precipitation window is introduced and described based on a terminal and a server. As shown in FIG. 6, the method in this embodiment of the present application may include the following steps.

In step S601, the terminal obtains battery working condition information and battery parameter information of a target battery.

In step S602, the terminal sends the battery working condition information and the battery parameter information of the target battery to the server.

In step S603, the server determines, from a battery model library based on the battery parameter information by using a method of automatically retrieving a database, target battery model information matching the battery parameter information.

It should be noted that, after obtaining the matched target battery model information, the server may further send the target battery model information to the terminal, so that a user confirms the target battery model information, and step S604 is performed after the confirmation by the user, which is beneficial to improve the obtaining efficiency of the battery lithium precipitation window.

In step S604, the server establishes an electrochemical model of the target battery based on the target battery model information, and performs, by using the electrochemical model of the target battery, simulation processing on a battery charging process corresponding to the battery working condition information, so as to obtain a lithium precipitation window corresponding to the battery working condition information.

In step S605, the server sends, to the terminal, the lithium precipitation window corresponding to the battery working condition information.

For an implementation of each step in this embodiment of the present application, reference may be made to related content in the above embodiment of the present application, and details are not repeated here.

In this embodiment of the present application, the server uses the method of performing, by using the electrochemical model of the target battery that is established based on the target battery model information automatically matched, simulation processing on the battery charging process corresponding to the battery working condition information, so that battery lithium precipitation windows corresponding to different battery working conditions and/or different battery parameters can be calculated without a need to make test batteries, which can not only reduce a test period, but also save a large amount of test resources, thereby helping increase a research and development speed and save research and development costs. In addition, in this embodiment of the present application, the terminal uses the method in which the server performs simulation processing on the battery charging process to obtain the lithium precipitation window corresponding to the battery working condition information, requiring relatively low processing capacity of the terminal, which is beneficial to the application of the method for obtaining a battery lithium precipitation window in this embodiment of the present application to different terminals.

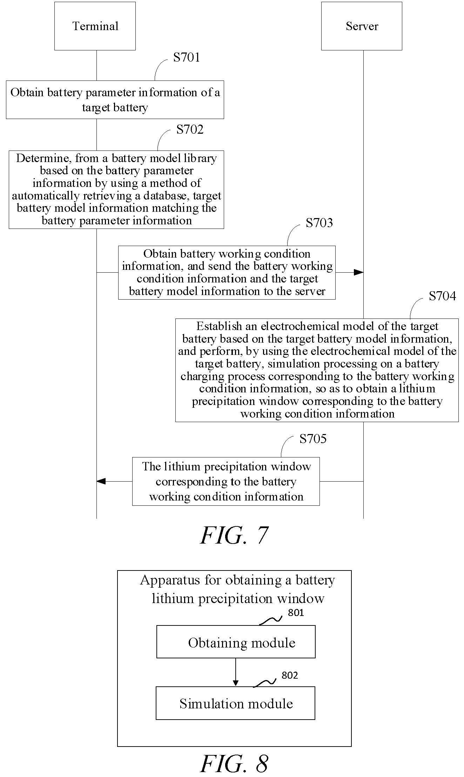

In some embodiments, FIG. 7 is a schematic flowchart of a method for obtaining a battery lithium precipitation window according to some other embodiments of the present application. On the basis of the above embodiment, in this embodiment of the present application, the method for obtaining a battery lithium precipitation window is introduction and description based on a terminal and a server. As shown in FIG. 7, the method in this embodiment of the present application may include the following steps.

In step S701, the terminal obtains battery parameter information of a target battery.

In step S702, the terminal determines, from a battery model library based on the battery parameter information by using a method of automatically retrieving a database, target battery model information matching the battery parameter information.

In this step, the method of determining, from the battery model library by the terminal, the target battery model information matching the battery parameter information is used, so that a user may confirm the target battery model information, and step S703 is performed after the confirmation by the user, which is beneficial to improve the obtaining efficiency of the battery lithium precipitation window.

In a possible implementation, if a confirmation signal from the user on the target battery model information determined in step S702 has not been received beyond a preset duration threshold, the terminal may perform step S702 again until the user confirms.

In another possible implementation, if a confirmation signal from the user for verifying the target battery model information determined in step S702 has not been received beyond a preset duration threshold, the terminal may modify the target battery model information determined in step S702 according to an instruction of the user, and then send the modified target battery model information to the server.

In step S703, the terminal obtains battery working condition information, and sends the battery working condition information and the target battery model information to the server.

In step S704, the server establishes an electrochemical model of the target battery based on the target battery model information, and performs, by using the electrochemical model of the target battery, simulation processing on a battery charging process corresponding to the battery working condition information, so as to obtain a lithium precipitation window corresponding to the battery working condition information.

In step S705, the server sends, to the terminal, the lithium precipitation window corresponding to the battery working condition information.

For an implementation of each step in this embodiment of the present application, reference may be made to related content in the above embodiment of the present application, and details are not repeated here.

In this embodiment of the present application, the target battery model information matching the battery parameter information is determined from the battery model library by the terminal. Further, the method of performing, by the server by using the electrochemical model of the target battery that is established based on the target battery model information sent by the terminal, simulation processing on the battery charging process corresponding to the battery working condition information can not only reduce a test period, but also save a large amount of test resources, thereby helping improve the obtaining efficiency of the battery lithium precipitation window. In addition, in this embodiment of the present application, the terminal uses the method in which the server performs simulation processing on the battery charging process to obtain the lithium precipitation window corresponding to the battery working condition information, which requires relatively low processing capacity of the terminal, which is beneficial to the application of the method for obtaining a battery lithium precipitation window in this embodiment of the present application to different terminals.

It should be understood that although the steps in the flowchart that are involved in the embodiments described above are displayed in sequence as indicated by arrows, these steps are not necessarily sequentially executed in the order indicated by the arrows. Unless explicitly described herein, the execution of these steps is not limited to a strict order, instead, the steps may be executed in another order. In addition, at least some of the steps in the flowchart that are involved in the embodiments described above may include multiple steps or multiple stages. These steps or stages are not necessarily executed or completed at the same moment, but can be executed at different moments. These steps or stages are also not necessarily executed in sequence, but can be executed in turn or alternately with at least some of other steps or steps or stages of other steps.

Based on the same inventive concept, an embodiment of the present application further provides an obtaining apparatus for implementing the above method for obtaining a battery lithium precipitation window. An implementation solution for solving the problems that is provided by the apparatus is similar to the implementation solution of the above method. Therefore, for specific definitions of one or more embodiments of the apparatus for obtaining a battery lithium precipitation window provided below, reference may be made to the definitions of the above method for obtaining a battery lithium precipitation window, and details are not described herein again.

In some embodiments, FIG. 8 is a schematic diagram of a structure of an apparatus for obtaining a battery lithium precipitation window according to some embodiments of the present application. The apparatus for obtaining a battery lithium precipitation window provided in this embodiment of the present application may be applied to an electronic device. As shown in FIG. 8, the apparatus for obtaining a battery lithium precipitation window in this embodiment of the present application may include: an obtaining module 801 and a simulation module 802.

The obtaining module 801 is configured to obtain battery working condition information and an electrochemical model of a target battery.

The simulation module 802 is configured to perform, by using the electrochemical model of the target battery, simulation processing on a battery charging process corresponding to the battery working condition information, so as to obtain a lithium precipitation window corresponding to the battery working condition information.

In some embodiments, the obtaining module 801 includes:
an obtaining unit configured to obtain target battery model information corresponding to the target battery; and
an establishment unit configured to establish the electrochemical model of the target battery based on the target battery model information.

In some embodiments, the obtaining unit is specifically configured to:
obtain battery parameter information of the target battery; and
determine, from a battery model library based on the battery parameter information, the target battery model information matching the battery parameter information.

In some embodiments, the battery parameter information includes battery material information, and the obtaining unit is specifically configured to:
determine, from the battery model library based on the battery material information, the target battery model information matching the battery material information.

In some embodiments, the battery parameter information includes battery design information, and the obtaining unit is specifically configured to:
determine, from the battery model library based on the battery design information, the target battery model information matching the battery design information.

In some embodiments, the battery parameter information includes battery material information and battery design information, and the obtaining unit is specifically configured to:
determine, from the battery model library based on the battery material information, candidate battery model information matching the battery material information; and
determine, from the candidate battery model information based on the battery design information, the target battery model information matching the battery design information.

In some embodiments, the battery material information includes at least one of positive and negative electrode material information, separator material information, electrolyte material information, and current collector material information.

In some embodiments, the battery design information includes at least one of a battery capacity, a compacted density, a capacity per gram, and an electrode plate size.

In some embodiments, the battery working condition information includes a target temperature and a target state of charge (SOC), and the simulation module 802 includes:
a simulation unit configured to perform simulation processing on the battery charging process under the target temperature by using the electrochemical model of the target battery, so as to obtain a mapping relationship between a maximum charge rate and a SOC corresponding to the target temperature; and
a determining unit configured to determine, based on the target SOC and the mapping relationship, a lithium precipitation window corresponding to the target SOC.

In some embodiments, the battery charging process includes a process of charging a battery at different maximum charge rates from when a remaining electricity amount of the battery is an initial SOC, and the simulation unit is specifically configured to:
perform simulation processing on the battery charging process under the target temperature by using the electrochemical model of the target battery, so as to obtain a plurality of groups of simulation results, where each group of simulation results includes a maximum charge rate and a corresponding SOC; and
obtain the mapping relationship based on the plurality of groups of simulation results.

In some embodiments, the determining unit is specifically configured to:
obtain, based on the target SOC and the mapping relationship, a target maximum charge rate corresponding to the target SOC; and
determine the lithium precipitation window based on the target maximum charge rate and a battery capacity of the target battery.

The apparatus for obtaining a battery lithium precipitation window provided in this embodiment of the present application may be configured to perform the technical solutions in the embodiments of the above method for obtaining a battery lithium precipitation window in the present application, and implementation principles and technical effects thereof are similar. Details are not described herein again.

All or some of the various modules in the above apparatus for obtaining a battery lithium precipitation window may be implemented by software, hardware, and a combination thereof. The modules above may be embedded in or independent of a processor in an electronic device in the form of hardware, and may also be stored in a memory of the electronic device in the form of software, so that the processor invokes the corresponding operations executing the modules above.

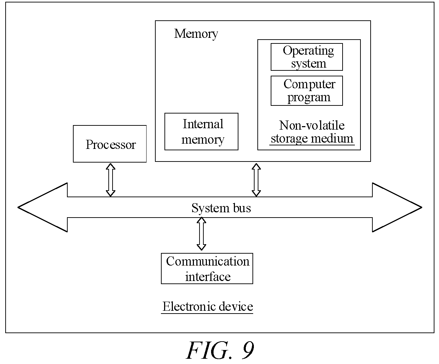

In an embodiment, FIG. 9 is a schematic diagram of a structure of an electronic device according to an embodiment of the present application. The electronic device in this embodiment of the present application may include, but is not limited to, a terminal or a server. As shown in FIG. 9, the electronic device includes a processor, a memory, and a communications interface that are connected through a system bus. The processor of the electronic device is configured to provide computing and control capabilities. The memory of the electronic device includes a non-volatile storage medium and an internal memory. The non-volatile storage medium stores an operating system and a computer program. The internal memory provides an environment for operation of the operating system and the computer program in the non-volatile storage medium. The communication interface of the electronic device is used for wired or wireless communication with an external device. When the computer program is executed by the processor, the technical solutions in the embodiments of the method for obtaining a battery lithium precipitation window in the present application are implemented, and implementation principles and technical effects thereof are similar. Details are not described herein again.

Those skilled in the art can understand that a structure shown in FIG. 9 is merely a block diagram of a part of the structure related to the solutions of the present application, and does not constitute a limitation on the electronic device to which the solutions of the present application are applied. Specifically, the electronic device may include more or fewer components than those shown in the drawings, or have some components combined, or have different component arrangements.

In some embodiments, an electronic device is further provided, including a memory and a processor. The memory stores a computer program. When the processor executes the computer program, the technical solutions in the embodiments of the method for obtaining a battery lithium precipitation window in the present application are implemented, and implementation principles and technical effects thereof are similar. Details are not described herein again.

In some embodiments, a computer-readable storage medium is further provided. The computer-readable storage medium stores a computer program. When the computer program is executed by a processor, the technical solutions in the embodiments of the method for obtaining a battery lithium precipitation window in the present application are implemented, and implementation principles and technical effects thereof are similar. Details are not described herein again.

In some embodiments, a computer program product is further provided, including a computer program. When the computer program is executed by a processor, the technical solutions in the embodiments of the method for obtaining a battery lithium precipitation window in the present application are implemented, and implementation principles and technical effects thereof are similar. Details are not described herein again.

Those skilled in the art can understand that all or some of the procedures in the methods in the above embodiments can be implemented by a computer program instructing related hardware. The computer program may be stored in a non-volatile computer-readable storage medium. The computer program, when executed, may include the procedures of the foregoing method embodiments. Any reference to a memory, a database, or other media used in the embodiments provided in the present application may include at least one of a non-volatile memory and/or a volatile memory. The non-volatile memory may include a read-only memory (ROM), a magnetic tape, a floppy disk, a flash memory, an optical memory, a high-density embedded non-volatile memory, a resistive random access memory (ReRAM), a magnetoresistive random access memory (MRAM), a ferroelectric random access memory (FRAM), a phase change memory (PCM), a graphene memory, etc. The volatile memory may include a random access memory (RAM), an external cache memory, etc. By way of illustration but not limitation, the RAM may be in various forms, such as a static random access memory (SRAM) or a dynamic random access memory (DRAM). The database involved in the embodiments provided in the present application may include at least one of a relational database and a non-relational database. The non-relational database may include a blockchain-based distributed database, etc., and is not limited thereto. The processor involved in the embodiments provided in the present application may be a general-purpose processor, a central processor, a graphics processor, a digital signal processor, a programmable logic device, a quantum computing-based data processing logic device, etc., and is not limited thereto.

Finally, it should be noted that the above embodiments are merely used for illustrating rather than limiting the technical solutions of the present application. Although the present application has been illustrated in detail with reference to the foregoing embodiments, it should be understood by those of ordinary skill in the art that the technical solutions described in the foregoing embodiments may still be modified, or some or all of the technical features thereof may be equivalently substituted; and such modifications or substitutions do not make the essence of the corresponding technical solution depart from the scope of the technical solutions of the embodiments of the present application, and should fall within the scope of the claims and the description of the present application. In particular, the technical features mentioned in the embodiments can be combined in any manner, provided that there is no structural conflict. The present application is not limited to the specific embodiments disclosed herein but includes all the technical solutions that fall within the scope of the claims.

## Claims

1. A method for obtaining a battery lithium precipitation window, comprising:
obtaining battery working condition information and an electrochemical model of a target battery; and
performing, by using the electrochemical model of the target battery, simulation processing on a battery charging process corresponding to the battery working condition information, so as to output a lithium precipitation window corresponding to the battery working condition information.

2. The method according to claim 1, wherein obtaining the electrochemical model of the target battery comprises:
obtaining target battery model information corresponding to the target battery; and
establishing the electrochemical model of the target battery based on the target battery model information.

3. The method according to claim 2, wherein the obtaining target battery model information corresponding to the target battery comprises:
obtaining battery parameter information of the target battery; and
determining, from a battery model library based on the battery parameter information, the target battery model information matching the battery parameter information.

4. The method according to claim 3, wherein the battery parameter information comprises battery material information, and the determining, from a battery model library based on the battery parameter information, the target battery model information matching the battery parameter information comprises:
determining, from the battery model library based on the battery material information, the target battery model information matching the battery material information.

5. The method according to claim 3, wherein the battery parameter information comprises battery design information, and the determining, from a battery model library based on the battery parameter information, the target battery model information matching the battery parameter information comprises:
determining, from the battery model library based on the battery design information, the target battery model information matching the battery design information.

6. The method according to claim 3, wherein the battery parameter information comprises battery material information and battery design information, and the determining, from a battery model library based on the battery parameter information, the target battery model information matching the battery parameter information comprises:
determining, from the battery model library based on first information in the battery material information and the battery design information, candidate battery model information matching the first information;
determining, from the candidate battery model information based on second information in the battery material information and the battery design information, the target battery model information matching the second information, wherein the second information is information other than the first information in the battery material information and the battery design information.

7. The method according to claim 3, wherein the battery parameter information comprises battery material information and battery design information, and the determining, from a battery model library based on the battery parameter information, the target battery model information matching the battery parameter information comprises:
determining, from the battery model library based on the battery material information, first candidate battery model information matching the battery material information;
determining, from the battery model library based on the battery design information, second candidate battery model information matching the battery design information; and
determining the target battery model information based on the first candidate battery model information and the second candidate battery model information.

8. The method according to claim 4, 6, or 7, wherein the battery material information comprises at least one of positive and negative electrode material information, separator material information, electrolyte material information, and current collector material information.

9. The method according to claim 5, 6, or 7, wherein the battery design information comprises at least one of a battery capacity, a compacted density, a capacity per gram, and an electrode plate size.

10. The method according to any one of claims 1 to 7, wherein the battery working condition information comprises a target temperature and a target state of charge (SOC), and the performing, by using the electrochemical model of the target battery, simulation processing on a battery charging process corresponding to the battery working condition information, so as to obtain a lithium precipitation window corresponding to the battery working condition information comprises:
performing simulation processing on the battery charging process under the target temperature by using the electrochemical model of the target battery, so as to obtain a mapping relationship between a maximum charge rate and a SOC corresponding to the target temperature; and
determining, based on the target SOC and the mapping relationship, a lithium precipitation window corresponding to the target SOC.

11. The method according to claim 10, wherein the battery charging process comprises a process of charging a battery at different maximum charge rates from when a remaining electricity amount of the battery is an initial SOC, wherein the performing simulation processing on the battery charging process under the target temperature by using the electrochemical model of the target battery, so as to obtain a mapping relationship between a maximum charge rate and a SOC corresponding to the target temperature comprises:
performing simulation processing on the battery charging process under the target temperature by using the electrochemical model of the target battery, so as to obtain a plurality of groups of simulation results, wherein each group of simulation results comprises a maximum charge rate and a corresponding SOC; and
obtaining the mapping relationship based on the plurality of groups of simulation results.

12. The method according to claim 10, wherein the determining, based on the target SOC and the mapping relationship, a lithium precipitation window corresponding to the target SOC comprises:
obtaining, based on the target SOC and the mapping relationship, a target maximum charge rate corresponding to the target SOC; and
determining the lithium precipitation window based on the target maximum charge rate and a battery capacity of the target battery.

13. An apparatus for obtaining a battery lithium precipitation window, comprising:
an obtaining module configured to obtain battery working condition information and an electrochemical model of a target battery; and
a simulation module configured to perform, by using the electrochemical model of the target battery, simulation processing on a battery charging process corresponding to the battery working condition information, so as to output a lithium precipitation window corresponding to the battery working condition information.

14. An electronic device comprising a memory and a processor, wherein the memory stores a computer program, and the processor, when executing the computer program, implements steps of a method for obtaining a battery lithium precipitation window according to any one of claims 1 to 12.

15. A computer-readable storage medium storing a computer program, wherein the computer program, when executed by a processor, implements steps of a method for obtaining a battery lithium precipitation window according to any one of claims 1 to 12.

16. A computer program product comprising a computer program, wherein the computer program, when executed by a processor, implements steps of a method for obtaining a battery lithium precipitation window according to any one of claims 1 to 12.
